# EUROPEAN PATENT SPECIFICATION

(11) **EP 4 191 881 B1**
(45) Date of publication and mention of the grant of the patent: **18.03.2026**
(21) Application number: 22211210.4
(22) Date of filing: 02.12.2022
(51) Int. Cl.: H03K 3/03, H03B 5/00, H03L 7/00, H03L 7/099

(54) **GLITCH-FREE FREQUENCY TUNING OF RING-OSCILLATORS**
STÖRFREIE FREQUENZABSTIMMUNG VON RINGOSZILLATOREN
ACCORD DE FRÉQUENCE SANS IMPULSIONS TRANSITOIRES D'OSCILLATEURS EN ANNEAU

(30) Priority: 02.12.2021 US 202163285221 P
(43) Date of publication of application: 07.06.2023
(73) Proprietor: Qorvo US, Inc., Greensboro, NC 27409 (US)
(72) Inventor: KUENEN, Jeron Cornelis, 3511 SB Utrecht (NL); VISSER, Hendrik Arend, 3511 SB Utrecht (NL); ROODNAT, Anton Willem, 3511 SB Utrecht (NL); ZUPCAU, Dan Laurentiu, Fort Lauderdale FL 33309 (US)
(74) Representative: D Young & Co LLP

(56) References cited:
- US-A- 6 028 488
- US-A1- 2010 134 170
- US-A1- 2015 244 354
- US-B1- 9 401 703

## Description

### Related Applications

This application claims the benefit of provisional patent application serial number 63/285,221, filed December 2, 2021.

### Field of the Disclosure

The present disclosure relates to a ring-oscillator with glitch-free frequency tuning.

### Background

With the rapid development of wireless communication technologies, more and higher requirements are raised for electronic systems like wireless transceivers, data converters, or digital systems. Oscillators, which play a fundamental role in signal generation, waveform synthesizing, and timers, are essential parts of the electronic systems. For instance, in digital systems, oscillators are responsible for providing the clock that allows circuits in the digital system to perform sequential operations and gives the circuits the ability to precisely set the time of important events.

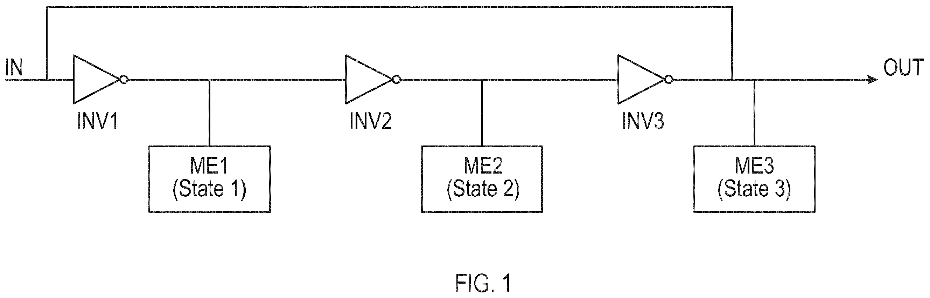

From area and tuning range perspectives, ring-oscillators are more attractive than inductor-capacitor oscillators. In addition, the ring-oscillators are fully integrable on silicon dies, have a fast startup time, and can provide multi-phase clock signals. Figure 1 illustrates a conventional structure of a ring-oscillator, which includes multiple inverters (e.g., three inverters INV1, INV2, and INV3) and corresponding memory elements (e.g., three memory elements ME1, ME2, and ME3, respectively). The three inverters are placed in series with an output of the last inverter INV3 being coupled back to an input of the first inverter INV1. There is no stable state, and so the circuit will oscillate. The frequency of oscillation is determined by a total delay in the ring loop. The fact that a delay needs to be made means that each inverter has a "state": memory of how far it is in its delay time. Normally, the memory elements may be implemented with capacitors, but inductors are also possible.

For many applications, like phase-lock-loops (PLLs), it is necessary to tune the frequency of the ring-oscillator. To achieve a precise and reliable performance, in many implementations an accurate frequency of the output from the ring-oscillator is critical. Glitches at the output, which are additional transitions at the output of the ring-oscillator and have a period time much shorter than an intended period, will significantly affect the performance of the application circuits.
Previously proposed arrangements are disclosed in US 2015/244354 A1, and US 2010/134170 A1.

### Summary

Particular aspects are set out in the appended independent claims. Various optional embodiments are set out in the dependent claims.

In some approaches, the present teachings may provide a ring-oscillator with glitch-free or substantially-glitch-free frequency-tuning.

The present disclosure relates to a ring-oscillator with glitch-free frequency-tuning. The disclosed ring-oscillator at least includes multiple delay stages with a first delay stage, a capacitor bank, and a timing block. The delay stages are coupled in series within a ring loop. The capacitor bank is coupled between an output of the first delay stage and ground. The timing block is configured to receive an output signal of the first delay stage and at least one controlling signal. Herein, the at least one controlling signal determines at least one capacitor in the capacitor bank connecting or disconnecting to the ring loop. When the output signal of the first delay stage meets a certain condition, the timing block is configured to pass the at least one controlling signal to the capacitor bank. When the output signal of the first delay stage does not meet the certain condition, the timing block is configured to latch the at least one controlling signal. As such, the connection or disconnection of the at least one capacitor in the capacitor bank does not cause a voltage at the output of the first delay stage to change beyond a threshold.

Those skilled in the art will appreciate the scope of the present disclosure and realize additional aspects thereof after reading the following detailed description of the example embodiments in association with the accompanying drawing figures.

### Brief Description of the Drawing Figures

The accompanying drawing figures incorporated in and forming a part of this specification illustrate several aspects of the disclosure, and together with the description serve to explain the principles of the disclosure.
Figure 1 shows a conventional ring-oscillator.
Figure 2 shows a multistage ring-oscillator with capacitor banks for frequency tuning.
Figure 3 shows an example ring-oscillator with glitch-free frequency-tuning according to one embodiment of the present disclosure.
Figures 4A-4B show example capacitor banks timing blocks used in the ring-oscillator shown in Figure 3.
Figures 5A-5C show example timing blocks used in the ring-oscillator shown in Figure 3.
Figures 6A-6B show simulation comparisons.

It will be understood that for clear illustrations, Figures 1-6B may not be drawn to scale.

### Detailed Description

The embodiments set forth below represent the necessary information to enable those skilled in the art to practice the embodiments and illustrate the best mode of practicing the embodiments. Upon reading the following description in light of the accompanying drawing figures, those skilled in the art will understand the concepts of the disclosure and will recognize applications of these concepts not particularly addressed herein. It should be understood that these concepts and applications fall within the scope of the disclosure and the accompanying claims.

It will be understood that, although the terms first, second, etc. may be used herein to describe various elements, these elements should not be limited by these terms. These terms are only used to distinguish one element from another. For example, a first element could be termed a second element, and, similarly, a second element could be termed a first element, without departing from the scope of the present disclosure. As used herein, the term "and/or" includes any and all combinations of one or more of the associated listed items.

It will be understood that when an element such as a layer, region, or substrate is referred to as being "on" or extending "onto" another element, it can be directly on or extend directly onto the other element or intervening elements may also be present. In contrast, when an element is referred to as being "directly on" or extending "directly onto" another element, there are no intervening elements present. Likewise, it will be understood that when an element such as a layer, region, or substrate is referred to as being "over" or extending "over" another element, it can be directly over or extend directly over the other element or intervening elements may also be present. In contrast, when an element is referred to as being "directly over" or extending "directly over" another element, there are no intervening elements present. It will also be understood that when an element is referred to as being "connected" or "coupled" to another element, it can be directly connected or coupled to the other element or intervening elements may be present. In contrast, when an element is referred to as being "directly connected" or "directly coupled" to another element, there are no intervening elements present.

Relative terms such as "below" or "above" or "upper" or "lower" or "horizontal" or "vertical" may be used herein to describe a relationship of one element, layer, or region to another element, layer, or region as illustrated in the Figures. It will be understood that these terms and those discussed above are intended to encompass different orientations of the device in addition to the orientation depicted in the Figures.

The terminology used herein is for the purpose of describing particular embodiments only and is not intended to be limiting of the disclosure. As used herein, the singular forms "a," "an," and "the" are intended to include the plural forms as well, unless the context clearly indicates otherwise. It will be further understood that the terms "comprises," "comprising," "includes," and/or "including" when used herein specify the presence of stated features, integers, steps, operations, elements, and/or components, but do not preclude the presence or addition of one or more other features, integers, steps, operations, elements, components, and/or groups thereof.

Unless otherwise defined, all terms (including technical and scientific terms) used herein have the same meaning as commonly understood by one of ordinary skill in the art to which this disclosure belongs. It will be further understood that terms used herein should be interpreted as having a meaning that is consistent with their meaning in the context of this specification and the relevant art and will not be interpreted in an idealized or overly formal sense unless expressly so defined herein.

Embodiments are described herein with reference to schematic illustrations of embodiments of the disclosure. As such, the actual dimensions of the layers and elements can be different, and variations from the shapes of the illustrations as a result, for example, of manufacturing techniques and/or tolerances, are expected. For example, a region illustrated or described as square or rectangular can have rounded or curved features, and regions shown as straight lines may have some irregularity. Thus, the regions illustrated in the figures are schematic and their shapes are not intended to illustrate the precise shape of a region of a device and are not intended to limit the scope of the disclosure. Additionally, sizes of structures or regions may be exaggerated relative to other structures or regions for illustrative purposes and, thus, are provided to illustrate the general structures of the present subject matter and may or may not be drawn to scale. Common elements between figures may be shown herein with common element numbers and may not be subsequently re-described.

Providing a large frequency tuning range is one of the most important features of a ring-oscillator. However, in conventional tuning methods, glitches (i.e., additional pulses) may occur at an output of the ring-oscillator, which makes the ring-oscillator unsuitable for many applications, like for example, clocking digital circuitry.

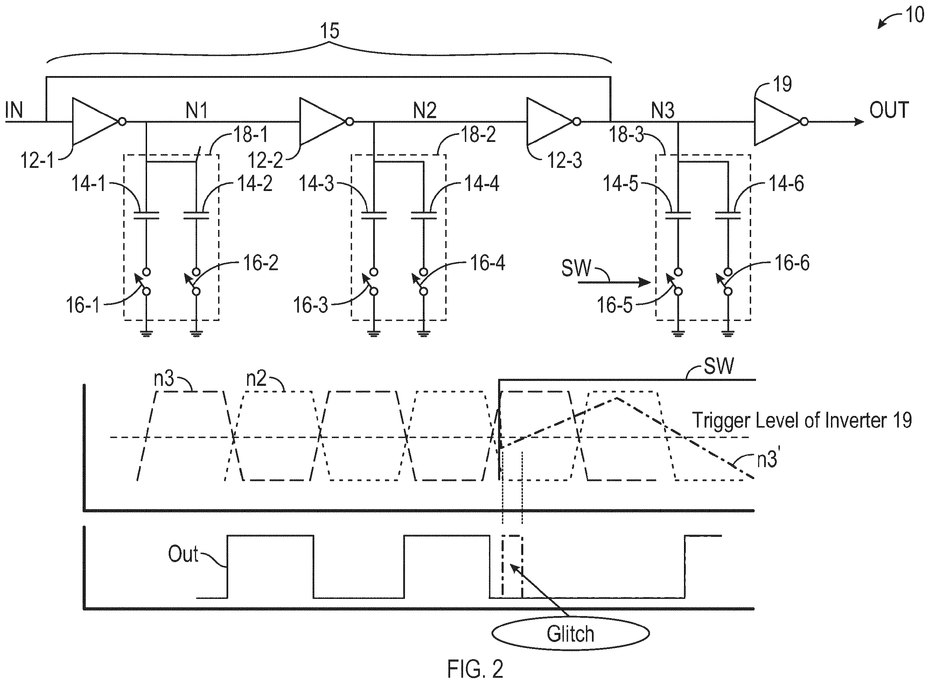

Figure 2 shows a multistage ring-oscillator 10 with capacitor banks for frequency tuning. The multistage ring-oscillator 10 includes three loop inverters 12 (e.g., a first loop inverter 12-1, a second loop inverter 12-2, and a third loop inverter 12-3) and corresponding capacitors 14 (e.g., a first capacitor 14-1, a second capacitor 14-2, a third capacitor 14-3, a fourth capacitor 14-4, a fifth capacitor 14-5, and a sixth capacitor 14-6). Herein, the three loop inverters 12 are coupled in series within a ring loop 15, where an input IN of the ring-oscillator 10 is an input of the first loop inverter 12-1, an output N1 of the first loop inverter 12-1 is coupled to an input of the second loop inverter 12-2, an output N2 of the second loop inverter 12-2 is coupled to an input of the third loop inverter 12-3, and an output N3 of the third loop inverter 12-3 is coupled back to the input of the first loop inverter 12-1. The first and second capacitors 14-1 and 14-2 are coupled between the output N1 of the first loop inverter 12-1 and ground via a first switch 16-1 and a second switch 16-2, respectively. The first capacitor 14-1, the second capacitor 14-2, the first switch 16-1, and the second switch 16-2 form a first capacitor bank 18-1. The third and fourth capacitors 14-3 and 14-4 are coupled between the output N2 of the second loop inverter 12-2 and ground via a third switch 16-3 and a fourth switch 16-4, respectively. The third capacitor 14-3, the fourth capacitor 14-4, the third switch 16-3, and the fourth switch 16-4 form a second capacitor bank 18-2. The fifth and sixth capacitors 14-5 and 14-6 are coupled between the output N3 of the third loop inverter 12-3 and ground via a fifth switch 16-5 and a sixth switch 16-6, respectively. The fifth capacitor 14-5, the sixth capacitor 14-6, the fifth switch 16-5, and the sixth switch 16-6 form a third capacitor bank 18-3. The first, second, capacitor banks 18-1-18-3 are one possible implementation of the memory elements as shown in Figure 1. In addition, the multistage ring-oscillator 10 may also include an output inverter 19, where an input of the output inverter 19 is coupled to the output N3 of the third loop inverter 12-3 and an output of the output inverter 19 is an output OUT of the ring-oscillator 10.

By selectively connecting the capacitors 14-1-14-6 (by selectively turning on the switches 16-1-16-6) to the ring loop 15, the frequency at the output OUT of the ring-oscillator 10 can be tuned. The more capacitors that are connected to the ring loop 15, the more the delay and therefore the lower the frequency at the output OUT of the ring-oscillator 10. For some conventional tuning methods, the capacitor connecting may be performed at a random moment in a cycle of the ring-oscillator by a cap controller (not shown). The timing of the capacitor connecting and the signal through the ring-oscillator 10 are asynchronous. If the timing of the capacitor connecting is not chosen accurately, a glitch at the output OUT of the ring-oscillator 10 arises.

As shown in Figure 2, when the fifth capacitor 14-5 is connected to the ring loop 15 (i.e., the fifth switch 16-5 becomes conducting) at a high signal level of the output N3 of the third loop inverter 12-3, a glitch at the output OUT of the ring-oscillator 10 arises. It is assumed that, initially, none of the capacitors 14 are connected to the ring loop 15, and each switched-off capacitor 14 is discharged to 0V due to leakage of the switches 16. Voltage signals at the output N2 of the second loop inverter 12-2 and at the output N3 of the third loop inverter 12-3 are shown as n2 and n3 respectively. In this example, the fifth capacitor 14-5 is connected to the ring loop 15 by turning on the fifth switch 16-5 to reduce the frequency at the output OUT of the ring-oscillator 10. The moment of closing the fifth switch 16-5 is indicated with a SW line in the graph: when the SW line goes from low to high, the fifth switch 16-5 becomes conducting. Herein, the fifth switch 16-5 becomes conducting (i.e., the SW line goes high) when the n3 signal at the output N3 of the third loop inverter 12-3 is high. At that moment, a charge redistribution takes place at the fifth capacitor 14-5. It is assumed in this example, that all other switches 14 remain off all the time. Due to the charge redistribution, the voltage at the output N3 of the third loop inverter 12-3 drops as shown with a dashed curve n3'.

A square wave Out is provided by the output inverter 19 based on the voltage at the output N3 of the third loop inverter 12-3 (i.e., n3 voltage before the fifth switch 16-5 conducting and n3' voltage after the fifth switch 16-5 conducting). Due to a momentary crossing of the voltage n3' across the trigger level of the output inverter 19, a short pulse is generated at the output of the output inverter 19 (i.e., the output OUT of the ring-oscillator 10). In this example, the short pulse happens shortly after the previous transition pulse: a glitch is born. As such, the output frequency of the ring-oscillator 10 increases but not decreases. If the square wave signal Out would be used as a clock signal for a digital circuit, the timing constraints would be violated, and the digital circuit would be brought in an unknown and possibly unwanted state. Furthermore, a power supply of one ring-oscillator is often done with a single current source to reduce its phase noise. However, when one capacitor is conducting (e.g., the fifth switch 16-5 conducting), while the corresponding capacitor bank (e.g., the third capacitor bank 18-3) is charged, a dip will result on the power supply and affect all loop inverters 12. This makes the effect of turning on one capacitor at an incorrect moment even greater.

In another implementation, if the voltages over the switched-off capacitors 14 are different than 0V, the glitch issue may still exist. When one capacitor 14 is switched on at a random moment in a cycle of the ring-oscillator 10, its voltage may still differ from the voltage at the output of the corresponding loop inverter 12. Therefore, once the capacitor is conducted, the charge redistribution will still happen, and a sudden and significant change in voltage will still occur at the output of the corresponding loop inverter 12, which will lead to the glitch.

Notice that, for the ring-oscillator 10, if the capacitor 14 is connected to or disconnected from the ring loop 15 only when the output voltage of the corresponding loop inverter 12 is at or close to zero volt, there will be no significant charge redistribution to the capacitor 14, and therefore, no significant change in voltage will occur at the output of the corresponding loop inverter 12 (i.e., the change in voltage at the output of the corresponding loop inverter 12 is not exceeding a threshold, such as not beyond the trigger level of the output inverter 19). In consequence, the voltage level at the output OUT of the ring-oscillator 10 will remain the same (i.e., not glitch).

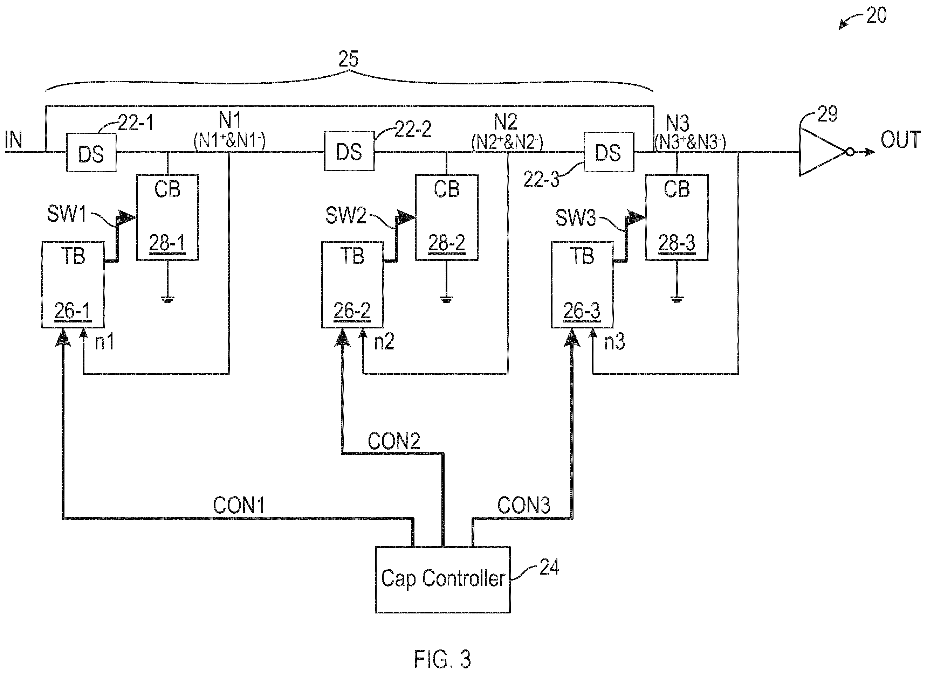

Figure 3 shows an example ring-oscillator 20 with glitch-free frequency-tuning according to one embodiment of the present disclosure. For the purpose of this illustration, the ring-oscillator 20 includes three delay stages (DSs) 22 (e.g., a first delay stage 22-1, a second delay stage 22-2, and a third delay stage 22-3), a cap controller 24, three timing blocks (TBs) 26 (e.g., a first timing block 26-1, a second timing block 26-2, and a third timing block 26-3), three capacitor banks (CBs) 28 (e.g., a first capacitor bank 28-1, a second capacitor bank 28-2, and a third capacitor bank 28-3), and an output inverter 29. In different applications, the ring-oscillator 20 may include more delay stages 22, more or fewer timing blocks 26, more or fewer capacitor banks 28, and more output inverters 29.

Herein, the three delay stages 22 are coupled in series in a ring loop 25, where an input IN of the ring-oscillator 20 is an input of the first delay stage 22-1, an output N1 of the first delay stage 22-1 is coupled to an input of the second delay stage 22-2, an output N2 of the second delay stage 22-2 is coupled to an input of the third delay stage 22-3, and an output N3 of the third delay stage 22-3 is coupled back to the input of the first delay stage 22-1. In addition, an input of the output inverter 29 is coupled to the output N3 of the third delay stage 22-3 and an output of the output inverter 29 is an output OUT of the ring-oscillator 20. In the ring loop 25, there is always a 180-degree phase shift between adjacent delay stages 22, and the ring loop 25 is configured to provide an odd number of 180-degree shifts. As such, there is no stable state in the ring loop 25, and thus, the ring-oscillator 20 can oscillate. In some applications, there might be more than three delay stages 22 included in the ring loop 25, and these delay stages 22 are always coupled in series with an output of the last inverter fed back to an input of the first inverter and also coupled to the input of the output inverter 29. In some applications, the ring-oscillator 20 may include more than one output inverter 29 coupled to the output N1 of the first delay stage 22-1, the output N2 of the second delay stage 22-2, and/or the output N3 of the third delay stage 22-3, and correspondingly may provide more than one outputs (not shown).

In one embodiment, each delay stage 22 may be implemented by a single-end inverter or a differential-circuit inverter, and the 180-degree phase shifts in the ring loop 25 needed for oscillation are achieved by inversions of the inverters. In one embodiment, each delay stage 22 may be implemented by a differential-circuit buffer, and the 180-degree phase shifts in the ring loop 25 needed for oscillation are achieved by interchanging the differential signal from one buffer to the adjacent buffer. Herein, if the delay stages 22 are implemented by differential circuits, the input and output of each delay stage 22 are actually a differential input pair and a differential output pair (e.g., N1=>a pair of N1⁺ and N1⁻, N2=>a pair of N2⁺ and N2⁻, and N3=>a pair of N3⁺ and N3⁻), respectively.

Each capacitor bank 28 is coupled between the output of a corresponding delay stage 22 and ground (e.g., the first capacitor bank 28-1 is coupled between the output N1 of the first delay stage 22-1 and ground, the second capacitor bank 28-2 is coupled between the output N2 of the second delay stage 22-2 and ground, the third capacitor bank 28-3 is coupled between the output N3 of the third delay stage 22-3 and ground). If the delay stages 22 are implemented by differential circuits, for each delay stage 22, two identical capacitor banks 28 (instead of one capacitor bank 28) are coupled between the differential output pair of the corresponding delay stage 22 and ground, respectively (e.g., two identical first capacitor banks 28-1 are coupled between the output pair N1⁺ and N1⁻ of the first delay stage 22-1 and ground, respectively; two identical second capacitor banks 28-2 are coupled between the output pair N2⁺ and N2⁻of the second delay stage 22-2 and ground, respectively; two identical third capacitor banks 28-3 are coupled between the output pair N3⁺ and N3⁻ of the third delay stage 22-3 and ground , respectively, not shown). As such, the capacitance load is balanced for the differential structure.

In different applications, not every delay stage 22 is followed by the capacitor bank(s) 28. For a non-limited example, the ring-oscillator 20 only includes the third capacitor bank(s) 28-3, while the first capacitor bank(s) 28-1 and the second capacitor bank(s) 28-2 are omitted. For a non-limited example, the ring-oscillator 20 includes the first capacitor bank(s) 28-1 and the third capacitor bank(s) 28-3, while the second capacitor bank(s) 28-2 is omitted.

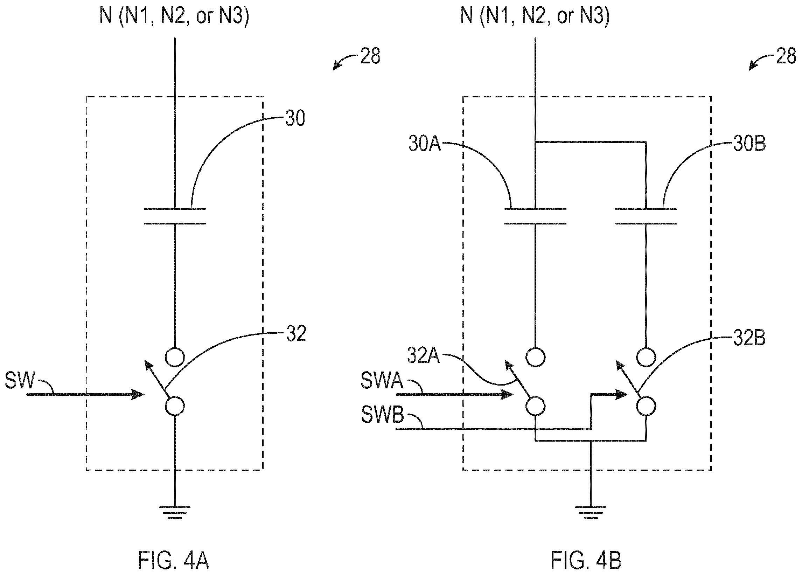

In detail, the cap controller 24 is configured to determine whether one or more capacitors in each capacitor bank 28 (capacitors are not shown in Figure 3, see Figures 4A-4B) should be connected to or disconnected from the ring loop 25. The one or more first controlling signals CON1 provided by the cap controller 24 determine which capacitor(s) in the first capacitor bank(s) 28-1 should be connected to or disconnected from the output N1 of the first delay stage 22-1. The one or more second controlling signals CON2 provided by the cap controller 24 determine which capacitor(s) in the second capacitor bank(s) 28-2 should be connected to or disconnected from the output N2 of the second delay stage 22-2. The one or more third controlling signals CON3 provided by the cap controller 24 determine which capacitor(s) in the third capacitor bank(s) 28-3 should be connected to or disconnected from the output N3 of the third delay stage 22-3.

Each timing block 26 is configured to determine, once one capacitor in a corresponding capacitor bank 28 is determined to be connected to or disconnected from the ring loop 25 by the cap controller 24, the timing at which such capacitor is connected to or disconnected from the ring loop 25. Each timing block 26 receives the corresponding controlling signal(s) CON from the cap controller 24 and one output signal n of a corresponding delay stage 22 to provide one or more switching signals SW to a corresponding capacitor bank 28 (e.g., the first timing block 26-1 receives the first controlling signal(s) CON1 from the cap controller 24 and the first signal n1 of the first delay stage 22-1 to provide the first switching signal(s) SW1 to the first capacitor bank 28-1, the second timing block 26-2 receives the second controlling signal(s) CON2 from the cap controller 24 and the second signal n2 of the second delay stage 22-2 to provide the second switching signal(s) SW2 to the second capacitor bank 28-2, and the third timing block 26-3 receives the third controlling signal(s) CON3 from the cap controller 24 and the third signal n3 of the third delay stage 22-3 to provide the third switching signal(s) SW3 to the third capacitor bank 28-3). Herein, once the output signal n (e.g., the first signal n1, the second signal n2, or the third signal n3) meets a particular condition (e.g., meets a threshold requirement, at a falling edge of a waveform, or other), the timing block 26 will pass the controlling signal(s) CON from the cap controller 24 to the corresponding capacitor bank 28 as the switching signal(s) SW. Each switching signal SW is a timed controlling signal CON. In other words, the timing at which the capacitor(s) of one capacitor bank 28 is connected to or disconnected from the ring loop 25 is monitoring/synchronized to the local output signal n of the corresponding delay stage 22. As such, each timing block 26 is able to control the timing of connecting or disconnecting the capacitor(s) in the corresponding capacitor bank 28 to the ring loop 25 (e.g., connecting or disconnecting the capacitor(s) when the output signal n of the corresponding loop inverter 22 is at or close to zero volt). This local timing control could lead to a small/negligible change in voltage at the output of the corresponding delay stage 22 (i.e., the change in voltage at the output of the corresponding delay stage 22 is not beyond a threshold, such as not beyond a trigger level of the next inverter) and thus no frequency glitch at the output OUT of the ring-oscillator 20. If one capacitor bank 28 is omitted, a corresponding timing block 26 is not needed.

It is important to note that, with the timing blocks 26, the cap controller 24 has no timing enforce. The cap controller 24 is configured to provide the controlling signals CON that are decoupled with any local or final output signal of the ring-oscillator 20 (e.g., the first output signal n1 of the first delay stage 22-1, the second output signal n2 of the second delay stage 22-2, the third output signal n3 of the third delay stage 22-3, or the output signal of the output inverter 29).

Herein, when the delay stages 22 are implemented by differential circuits, the output signal n of each delay stage 22 is a differential signal pair, and each delay stage 22 is followed by two identical capacitor banks 28. One timing block 26 utilizes either one of the differential output signals of a corresponding delay stage 22 to control when to pass the controlling signal(s) CON to the two identical capacitor banks 28 (e.g., the first timing block 26-1 utilizes one of the differential output signals of the first delay stage 22-1 to control when to pass the first controlling signal(s) CON1 to the two identical first capacitor banks 28-1, the second timing block 26-2 utilizes one of the differential output signals of the second delay stage 22-2 to control when to pass the second controlling signal(s) CON2 to the two identical second capacitor banks 28-2; and the third timing block 26-3 utilizes one of the differential output signals of the third delay stage 22-3 to control when to pass the third controlling signal(s) CON3 to the two identical third capacitor banks 28-3, not shown).

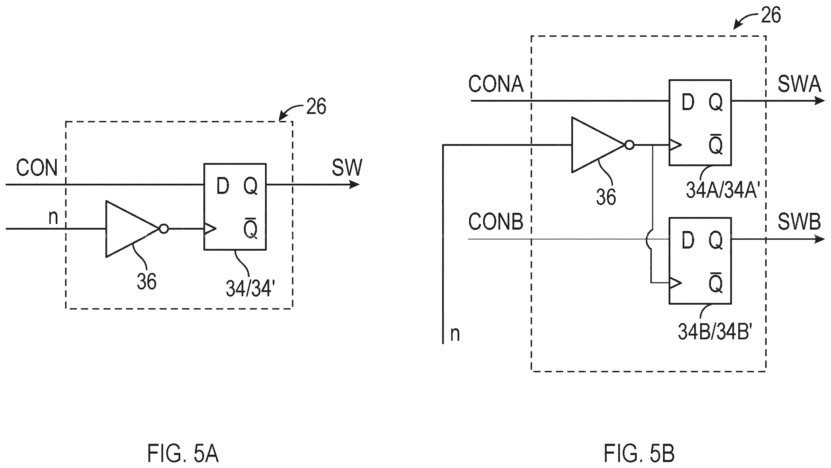

Figures 4A-4B show example implementations for one capacitor bank 28 (e.g., one first capacitor bank 28-1, one second capacitor bank 28-2, or one third capacitor bank 28-3), and Figures 5A-5C show example implementations for one timing block 26 (e.g., one first timing block 26-1, one second timing block 26-2, or one third timing block 26-3). When the capacitor bank 28 includes only one capacitor 30 and one switch 32 as illustrated in Figure 4A, the timing block 26 correspondingly includes one D-latch 34 and one block inverter 36 as illustrated in Figure 5A.

In the capacitor bank 28, the capacitor 30 and the switch 32 are coupled in series between an output N (e.g., N1, N2, or N3) of one delay stage 22 (e.g., the first delay stage 22-1, the second delay stage 22-2, or the third loop converter 22-3, respectively) and ground. Since the capacitor bank 28 includes only one switch 32 to connect or disconnect the capacitor 30, the capacitor bank 28 only needs one switching signal SW to alter the ON/OFF state of the switch 32. In the timing block 26, the D-latch 34 is configured to receive one controlling signal CON (e.g., the first controlling signal CON1, the second controlling signal CON2, or the third controlling signal CON3) from the cap controller 24 at a data input D of the D-latch 34 and an output signal n of one delay stage 22 (e.g., the first output signal n1 of the first delay stage 22-1, the second output signal n2 of the second delay stage 22-2, or the third output signal n3 of the third delay stage 22-3) at a clock input of the D-latch 34 through the block inverter 36, and configured to provide the switching signal SW at an output Q of the D-latch 34 to the switch 32 in the corresponding capacitor bank 28.

In this embodiment, when the output signal n of one delay stage 22 is low (e.g., lower than a threshold value/a trigger level of the block inverter 36, lower than a threshold value/a trigger level of the subsequent delay stage 22, like zero or close to zero), an output of the block inverter 36 is high, which enables the D-latch 34 to pass the received controlling signal CON to the output Q as the switching signal SW. The threshold value/the trigger level of one block inverter 36 and the threshold value/the trigger level of the subsequent delay stage 22 is the same (e.g., the threshold value/the trigger level of the block inverter 36 in the timing block 26-1 and the threshold value/the trigger level of the second delay stage 22-2 is the same). The switching signal SW is a timed version of the controlling signal CON. In other words, the controlling signal CON from the cap controller 24 will be scheduled to alter the ON/OFF state of the switch 32 when the output signal n of the delay stage 22 is low. When the output signal n of one delay stage 22 is high (e.g., higher than the threshold value/the trigger level of the block inverter 36, higher than the threshold value/the trigger level of the next delay stage 22), the output of the block inverter 36 is low, which disables the D-latch 34 to pass the received controlling signal CON to the output Q (i.e., latches the received controlling signal CON). Therefore, the ON or OFF state of the switch 32 remains unaltered.

In different applications, the D-latch 34 in the timing block 26 may be replaced by a D-flip-flop 34', which is configured to receive one controlling signal CON (e.g., the first controlling signal CON1, the second controlling signal CON2, or the third controlling signal CON3) from the cap controller 24 at a data input D of the D-flip-flop 34' and the output signal n of one delay stage 22 (e.g., the first output signal n1 of the first delay stage 22-1, the second output signal n2 of the second delay stage 22-2, or the third output signal n3 of the third delay stage 22-3) at a clock input of the D-flip-flop 34' through the block inverter 36, and configured to provide the switching signal SW at an output Q of the D-flip-flop 34' to the switch 32 in the corresponding capacitor bank 28. Herein, when the output signal n of one delay stage 22 is at a falling edge of a waveform, the output of the block inverter 36 provides a rising edge of the waveform, which enables the D-flip-flop 34' to pass the received controlling signal CON to the output Q as the switching signal SW. The controlling signal CON from the cap controller 24 will be scheduled to alter the ON/OFF state of the switch 32 when the output signal n of the delay stage 22 is at the falling edge of the waveform. When the output signal n of one delay stage 22 stays high or is at the rising edge of the waveform, the D-flip-flop 34' will not pass the received controlling signal CON to the output Q (i.e., hold the received controlling signal CON). Therefore, the ON or OFF state of the switch 32 remains unaltered.

Furthermore, in some applications, one capacitor bank 28 may include two or more capacitors 30 (e.g., an AA capacitor 30A and a BB capacitor 30B) and two or more corresponding switches 32 (e.g., an AA switch 32A and a BB switch 32B, respectively), as illustrated in Figure 4B. The AA capacitor 30A is parallel with the BB capacitor 30B, each of which is coupled between the output N (e.g., N1, N2, or N3) of one delay stage 22 (e.g., the first delay stage 22-1, the second delay stage 22-2, or the third loop converter 22-3, respectively) and ground via the corresponding switch 32. The capacitors 30 may be integrated capacitors, which match very well and make monotonic frequency tuning possible in a small die area. The switches 32 may be metal-oxide-semiconductor field-effect transistor (MOSFET) switches. When the switch 32 is conducting, the capacitor 30 is coupled to the ground, not a mid-rail voltage, yielding a good ON-OFF ratio of the MOSFET switch 32.

For the purpose of this illustration, the capacitor bank 28 includes two switches 32 to connect or disconnect the capacitors 30, the capacitor bank 28 needs two switching signals SW (e.g., an AA switching signal SWA and a BB switching signal SWB) to alter the ON/OFF states of the two switches 32 (e.g., the AA switching signal SWA controls the AA switch 32A and the BB switching signal SWB controls the BB switch 32B). The AA switching signal SWA and the BB switching signal SWB might be the first switching signals SW1 provided by the first timing block 26-1, or the second switching signals SW2 provided by the second timing block 26-2, or the third switching signals SW3 provided by the third timing block 26-3.

When the capacitor bank 28 includes two or more capacitors 30, the timing block 26 correspondingly includes two or more D-latches 34 (e.g., an AA D-latch 34A and a BB D-latch 34B) as illustrated in Figure 5B. In the timing block 26, the AA D-latch 34A is configured to receive an AA controlling signal CONA at a data input of the AA D-latch 34A and the output signal n of the corresponding delay stage 22 (e.g., the first output signal n1 of the first delay stage 22-1, the second output signal n2 of the second delay stage 22-2, or the third output signal n3 of the third delay stage 22-3) at a clock input of the AA D-latch 34A through the block inverter 36, and configured to provide the AA switching signal SWA at an output Q of the AA D-latch 34A to the AA switch 32A in the corresponding capacitor bank 28. The BB D-latch 34B is configured to receive a BB controlling signal CONB at a data input of the BB D-latch 34B and the output signal n of the corresponding delay stage 22 at a clock input of the BB D-latch 34B through the block inverter 36, and configured to provide the BB switching signal SWB at an output Q of the BB D-latch 34B to the BB switch 32B in the corresponding capacitor bank 28. Herein, the AA controlling signal CONA and the BB controlling signal CONB might be the first controlling signals CON1, or the second controlling signals CON2, or the third controlling signals CON3 provided by the cap controller 24.

In this embodiment, when the output signal n of one delay stage 22 is low (e.g., lower than a threshold value/a trigger level of the block inverter 36, lower than a threshold value/a trigger level of the next delay stage 22, like zero or close to zero), an output of the block inverter 36 is high, which enables the AA D-latch 34A to pass the received AA controlling signal CONA to the output Q of the AA D-latch 34A as the AA switching signal SWA and enables the BB D-latch 34B to pass the received BB controlling signal CONB to the output Q of the BB D-latch 34B as the BB switching signal SWB. The AA switching signal SWA is a timed version of the AA controlling signal CONA, and the BB switching signal SWB is a timed version of the BB controlling signal CONB. If the controlling signals CONA and CONB are separate signals, the switching signals SWA and SWB are separate signals as well. Herein, when the output signal n of the delay stage 22 is low, the controlling signals CONA and CONB from the cap controller 24 will be scheduled to alter the ON/OFF states of the switches 32A and 32B, respectively. In addition, when the output signal n of one delay stage 22 is high (e.g., higher than the threshold value/the trigger level of the block inverter 36, higher than the threshold value/the trigger level of the next delay stage 22), the output of the block inverter 36 is low, which disables the D-latches 34A and 34B to pass through the received controlling signals CONA and CONB, respectively. Therefore, the ON or OFF states of the switches 32A and 32B remain unaltered.

Similar to what is described above, in different applications, the D-latches 34A and 34B in the timing block 26 may be replaced by D-flip-flops 34A' and 34B'. When the output signal n of one delay stage 22 is at the falling edge of a waveform, the AA D-flip-flop 34A' can pass the received AA controlling signal CONA to the output Q of the AA D-flip-flop 34A' as the AA switching signal SWA so as to alter the ON/OFF states of the switch 32A, and the BB D-flip-flop 34B' can pass the received BB controlling signal CONB to the output Q of the BB D-flip-flop 34B' as the BB switching signal SWB so as to alter the ON/OFF state of the switch 32B.

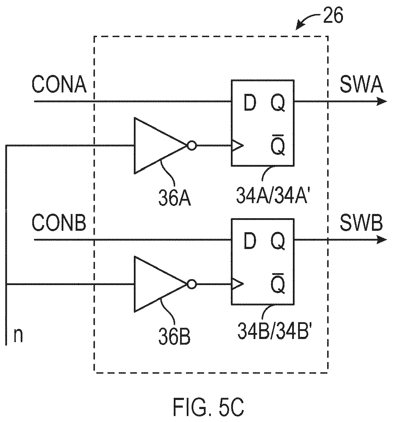

In Figure 5B, the AA D-latch 34A and the BB D-latch 34B (or the AA D-flip-flop 34A' and the BB D-flip-flop 34B') share a same block inverter 36 to get the inverted version of the output signal n of the delay stage 22. In some applications, each of the AA D-latch 34A (the AA D-flip-flop 34A') and the BB D-latch 34B (the BB D-flip-flop 34B') may have its own block inverter 36 (e.g., an AA block inverter 36A and a BB block inverter 36B) as illustrated in Figure 5C. The output signal n of the delay stage 22 is fed to the input of each of the AA block inverter 36A and the BB block inverter 36B.

Notice that each capacitor 30/switch 32 in one capacitor bank 28 corresponds to one specific D-latch 34 (one specific D-flip-flop 34') in the timing block 26. As such, the capacitors 30 included in a same capacitor bank 28 can be individually connected to or disconnected from the ring loop 25. In addition, the capacitors 30 followed by different delay stages 22 can be individually connected to or disconnected from the ring loop 25 (e.g., one capacitor 30 in the first capacitor bank 28-1 and one capacitor 30 in the second capacitor bank 28-2 can be controlled individually). Each timing block 26 is monitoring/synchronizing to the local output signal n of the corresponding delay stage 22 (e.g., the first timing block 26-1 is monitoring/synchronizing to the local output signal n1 of the first delay stage 22-1, the second timing block 26-2 is monitoring/synchronizing to the local output signal n2 of the second delay stage 22-2, and the third timing block 26-3 is monitoring/synchronizing to the local output signal n3 of the third delay stage 22-3). Different timing blocks 26 are monitoring/synchronizing different local output signals n. Therefore, the switching signals SW provided by different timing blocks 26 are still asynchronous.

In different applications, the capacitor bank 28 and the timing block 26 following different delay stages 22 may have different configurations. For a non-limited example, the first capacitor bank 28-1 and the first timing block 26-1 following the first delay stage 22-1 may be implemented as shown in Figures 4A and 5A, respectively; the second capacitor bank 28-2 and the second timing block 26-2 following the second delay stage 22-2 may be implemented as shown in Figures 4A and 5A, respectively; and the third capacitor bank 28-3 and the third timing block 26-3 following the third delay stage 22-3 may be implemented as shown in Figures 4B and 5B, respectively.

Besides avoiding glitches during tuning frequency, the ring-oscillator 20 benefits additional advantages. The asynchronous switching signals SW provided by different timing blocks 26 will yield a low-power consumption of the ring-oscillator 20 compared to a ring-oscillator with globally synchronized switching signals SW. For the ring-oscillator 20, when an update (i.e., connecting or disconnecting) moment is just missed, it will occur on the next clock cycle, which is for PLLs and many other applications a low enough delay (e.g., 5 ns max delay). In addition, connecting or disconnecting the capacitor(s) 30 does not disturb a power supply of the delay stages 22.

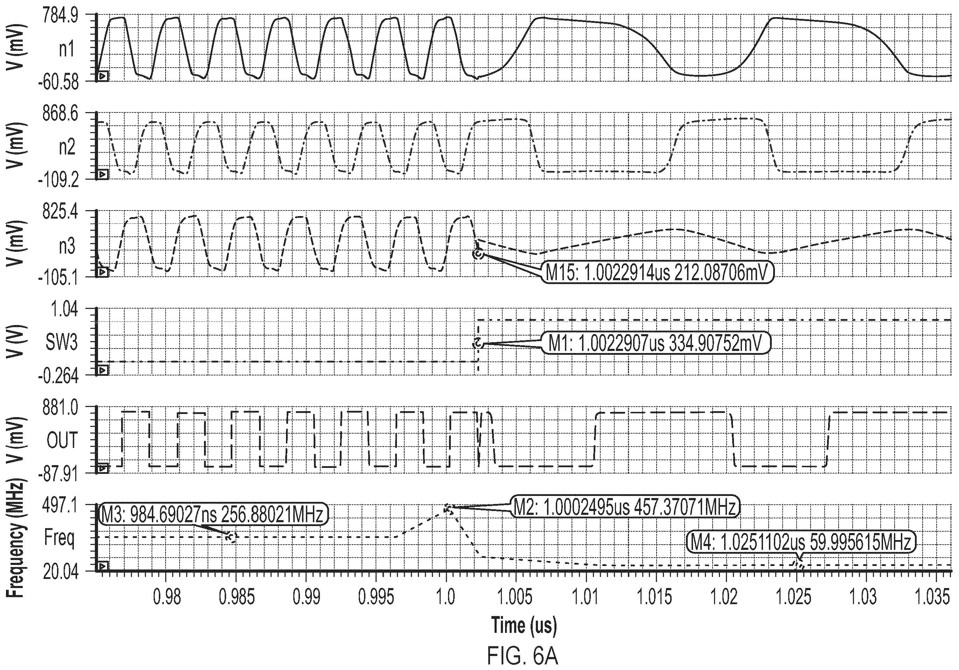

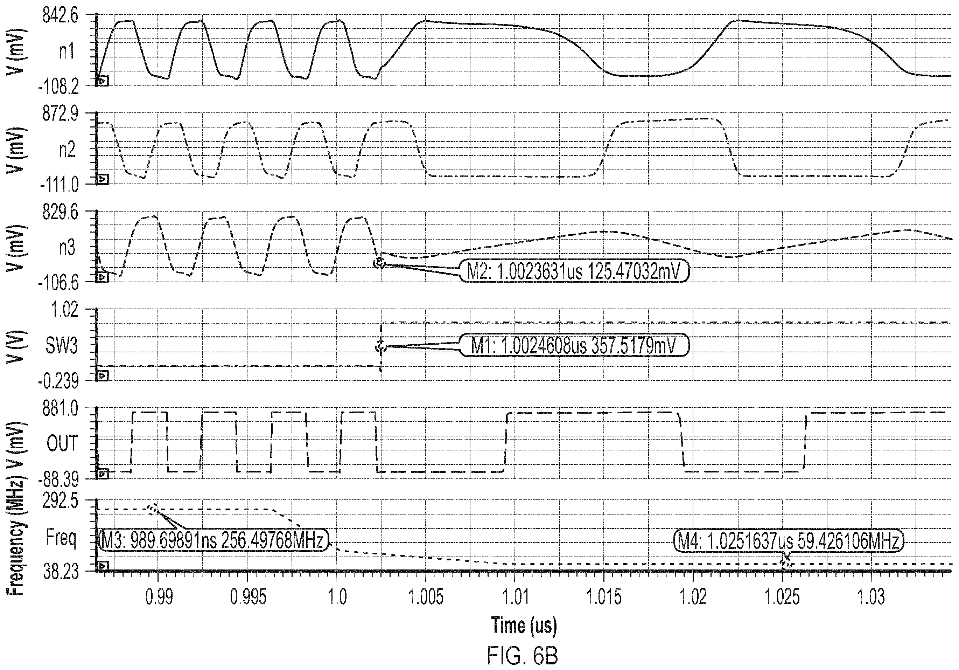

Figures 6A and 6B show simulation comparisons of frequency tuning between ring-oscillators with configurations shown in Figures 2 and 3, respectively. Herein, the intent is to change the oscillating frequency from 256.88MHz to 59.995MHz. The frequency tuning is achieved by altering capacitance loading at the output of the third delay stage 12-3 or 22-3 in the ring-oscillator 10 or 20, respectively.

Figure 6A shows simulation waveforms of frequency tuning for the conventional asynchronous ring-oscillator 10. The switching signal SW3, which controls the capacitance loading connected to the output N3 of the third delay stage 12-3, changes from low to high when the output signal n3 at the output N3 of the third delay stage 12-3 is not close to zero. Charge redistribution occurs at the output N3 of the third delay stage 12-3, which momentarily pulls the output signal n3 of the third delay stage 12-3 to a value below the inverting threshold of the output inverter 19. Consequently, the output inverter 19 switches to high and a high frequency glitch is generated at the output OUT of the ring-oscillator 10.

Figure 6B shows simulation waveforms of frequency tuning for the proposed asynchronous ring-oscillator 20, which has local timing (e.g., based on the output signal of a local corresponding delay stage 22) for connecting or disconnecting each capacitor in the capacitor banks. The switching signal SW3, which controls the capacitance loading connected to the output N3 of the third delay stage 22-3, changes from low to high only when the output signal n3 at the output N3 of the third delay stage 22-3 is close to zero. It is because the third timing block 26-3 provides timing control of the switching signal SW3 based on the output signal n3 of the third delay stage 22-3. Therefore, the voltage change at the output N3 of the third delay stage 22-3, due to small/negligible charge redistribution, is not sufficient to change the state of the output inverter 29. Consequently, high frequency glitch is avoided at the output OUT of the ring-oscillator 20.

Thus, from one perspective, there has been described a ring-oscillator with glitch-free frequency-tuning. The disclosed ring-oscillator at least includes multiple delay stages coupled in series within a ring loop and having a first delay stage, a capacitor bank coupled between an output of the first delay stage and ground, and a timing block configured to receive an output signal of the first delay stage and at least one controlling signal. The at least one controlling signal determines at least one capacitor in the capacitor bank connecting or disconnecting to the ring loop. The timing block is configured to pass or not pass the at least one controlling signal to the capacitor bank based on whether the output signal of the first delay stage meets a certain condition. Therefore, the connection or disconnection of the at least one capacitor does not cause a significant voltage change at the output of the first delay stage.

Those skilled in the art will recognize improvements and modifications to the example embodiments of the present disclosure. All such improvements and modifications are considered within the scope of the concepts disclosed herein and the claims that follow.

## Claims

1. A ring-oscillator (20) comprising:
• a plurality of delay stages (22-1, 22-2, 22-3) coupled in series within a ring loop (25), wherein the plurality of delay stages includes a first delay stage (22-1) and a second delay stage (22-2), which is a subsequent delay stage of the first delay stage, and coupled between the first delay stage and an output (OUT) of the ring-oscillator;
• a first capacitor bank (28-1) coupled between an output of the first delay stage and ground; and
• a first timing block (26-1) configured to receive an output signal (N1) of the first delay stage and at least one first controlling signal (CON1), wherein:
• the output of the first delay stage is coupled to an input of the second delay stage;
• the at least one first controlling signal determines at least one first capacitor in the first capacitor bank connecting or disconnecting to the ring loop; and
• when the output signal of the first delay stage meets a first certain condition, the first timing block is configured to pass the at least one first controlling signal to the first capacitor bank as at least one first switching signal, and when the output signal of the first delay stage does not meet the first certain condition, the first timing block is configured to disable passing the at least one first controlling signal to the first capacitor bank, such that the connection or disconnection of the at least one first capacitor does not cause a voltage at the output of the first delay stage to change beyond a first threshold being a trigger level of the second delay stage.

2. The ring-oscillator of claim 1 wherein:
• the first capacitor bank includes the at least one first capacitor and at least one first switch;
• the at least one first capacitor and the at least one first switch are coupled in series between the output of the first delay stage and ground; and
• the at least one first switch is controlled by the at least one first switching signal.

3. The ring-oscillator of claim 2 wherein the at least one first switch is a metal-oxide-semiconductor field-effect transistor (MOSFET) switch.

4. The ring-oscillator of claim 2 or 3 wherein:
• the first timing block includes at least one first D-latch and at least one first block inverter, wherein the first threshold is also a trigger level of the at least one first block inverter; and
• the at least one first D-latch is configured to receive the at least one first controlling signal at a data input of the at least one first D-latch and to receive the output signal of the first delay stage at a clock input of the at least one first D-latch through the at least one first block inverter, and configured to provide the at least one first switching signal to the at least one first switch in the first capacitor bank, wherein:
• when the output signal of the first delay stage is lower than the first threshold, the at least one first D-latch passes the at least one first controlling signal to the at least one first switch in the first capacitor bank as the at least one first switching signal; and
• when the output signal of the first delay stage is higher than the first threshold, at least one first D-latch holds the at least one first controlling signal.

5. The ring-oscillator of claim 2 or 3 wherein:
• the first timing block includes at least one first D-flip-flop and at least one first block inverter; and
• the at least one first D-flip-flop is configured to receive the at least one first controlling signal at a data input of the at least one first D-flip-flop and to receive the output signal of the first delay stage at a clock input of the at least one first D-flip-flop through the at least one first block inverter, and configured to provide the at least one first switching signal to the at least one first switch in the first capacitor bank, wherein:
• when the output signal of the first delay stage is at a falling edge of a signal waveform, the at least one first D-flip-flop passes the at least one first controlling signal to the at least one first switch in the first capacitor bank as the at least one first switching signal; and
• when the output signal of the first delay stage is not at the falling edge of the signal waveform, the at least one first D-flip-flop holds the at least one first controlling signal.

6. The ring-oscillator of any preceding claim wherein:
• the first capacitor bank includes a plurality of first capacitors and a plurality of first switches, wherein the at least one first capacitor is included in the plurality of first capacitors;
• each of the plurality of first capacitors and a corresponding one of the plurality of first switches are coupled in series between the output of the first delay stage and ground; and
• the at least one first switching signal includes a plurality of first switching signals, and each of the plurality of first switches is controlled by a corresponding one of the plurality of first switching signals.

7. The ring-oscillator of claim 6 wherein:
• the first timing block includes a plurality of first D-latches and a first block inverter, wherein the first threshold is also a trigger level of the first block inverter;
• the at least one first controlling signal includes a plurality of first controlling signals; and
• each of the plurality of first D-latches is configured to receive a corresponding one of the plurality of first controlling signals at a data input and to receive the output signal of the first delay stage at a clock input through the first block inverter, and configured to provide the corresponding one of the plurality of first switching signals to the corresponding one of the plurality of first switches in the first capacitor bank, wherein:
• when the output signal of the first delay stage is lower than the first threshold, each of the plurality of first D-latches passes the corresponding one of the plurality of first controlling signals to the corresponding switch of the plurality of first switches in the first capacitor bank as the corresponding one of the plurality of first switching signals; and
• when the output signal of the first delay stage is higher than the first threshold, each of the plurality of first D-latches holds the corresponding one of the plurality of first controlling signals.

8. The ring-oscillator of any preceding claim further comprising a second capacitor bank and a second timing block, wherein:
• the second capacitor bank is coupled between an output of the second delay stage and ground; and
• the second timing block is configured to receive an output signal of the second delay stage and at least one second controlling signal, wherein:
• the at least one second controlling signal determines at least one second capacitor in the second capacitor bank connecting or disconnecting to the ring loop; and
• when the output signal of the second delay stage meets a second certain condition, the second timing block is configured to pass the at least one second controlling signal to the second capacitor bank, and when the output signal of the second delay stage does not meet the second certain condition, the second timing block is configured to disable passing the at least one second controlling signal to the second capacitor bank, such that the connection or disconnection of the at least one second capacitor in the second capacitor bank does not cause a voltage at the output of the second delay stage to change beyond a second threshold being a trigger level of a subsequent delay stage of the second delay stage.

9. The ring-oscillator of claim 8 wherein:
• the first capacitor bank includes the at least one first capacitor and at least one first switch;
• the at least one first capacitor and the at least one first switch are coupled in series between the output of the first delay stage and ground;
• the at least one first switch is controlled by the at least one first switching signal;
• the second capacitor bank includes the at least one second capacitor and at least one second switch;
• the at least one second capacitor and the at least one second switch are coupled in series between the output of the second delay stage and ground; and
• the at least one second switch is controlled by the at least one second switching signal.

10. The ring-oscillator of claim 9 wherein:
• the first timing block includes at least one first D-latch and at least one first block inverter, wherein the first threshold is also a trigger level of the at least one first block inverter;
• the at least one first D-latch is configured to receive the at least one first controlling signal at a data input of the at least one first D-latch and to receive the output signal of the first delay stage at a clock input of the at least one first D-latch through the at least one first block inverter, and configured to provide the at least one first switching signal to the at least one first switch in the first capacitor bank, wherein:
• when the output signal of the first delay stage is lower than the first threshold, the at least one first D-latch passes the at least one first controlling signal to the at least one first switch in the first capacitor bank as the at least one first switching signal; and
• when the output signal of the first delay stage is higher than the first threshold, at least one first D-latch holds the at least one first controlling signal;
• the second timing block includes at least one second D-latch and at least one second block inverter, wherein the second threshold is also a trigger level of the at least one second block inverter; and
• the at least one second D-latch is configured to receive the at least one second controlling signal at a data input of the at least one second D-latch and to receive the output signal of the second delay stage at a clock input of the at least one second D-latch through the at least one second block inverter, and configured to provide the at least one second switching signal to the at least one second switch in the second capacitor bank, wherein:
• when the output signal of the second delay stage is lower than the second threshold, the at least one second D-latch passes the at least one second controlling signal to the at least one second switch in the second capacitor bank as at least one second switching signal; and
• when the output signal of the second delay stage is higher than the second threshold, at least one second D-latch holds the at least one second controlling signal.

11. The ring-oscillator of any preceding claim further comprising a plurality of capacitor banks and a plurality of timing blocks, wherein:
• the first capacitor bank is included in the plurality of capacitor banks, and the first timing block is included in the plurality of timing blocks;
• each of the plurality of capacitor banks is coupled between an output of a corresponding one of the plurality of delay stages and ground; and
• each of the plurality of timing blocks is configured to provide at least one switching signal to a corresponding one of the plurality of capacitor banks based on an output signal of the corresponding one of the plurality of delay stages;
• each of the plurality of delay stages is followed by a corresponding one of the plurality of capacitor banks.

12. The ring-oscillator of any preceding claim wherein the first certain condition is that the output signal of the first delay stage is lower than the first threshold.

13. The ring-oscillator of any preceding claim wherein the first certain condition is that the output signal of the first delay stage is at a falling edge of a waveform.

14. The ring-oscillator of any preceding claim wherein each of the plurality of delay stages is be implemented by a differential-circuit inverter, and 180-degree phase shifts in the ring loop needed for oscillation are achieved by one selected from the group comprising: inversions of the differential-circuit inverter; and interchanging differential signal from one differential-circuit buffer to an adjacent differential-circuit buffer.

15. The ring-oscillator of any preceding claim further comprising a cap controller, which is configured to provide the at least one first controlling signal, wherein the at least one first controlling signal is decoupled with any output signal at an output of each delay stage of the plurality of delay stages.

## Patentansprüche

1. Ringoszillator (20), der Folgendes umfasst:
• mehrere Verzögerungsstufen (22-1, 22-2, 22-3), die mit einer Ringschleife (25) in Reihe geschaltet sind, wobei die mehreren Verzögerungsstufen eine erste Verzögerungsstufe (22-1) und eine zweite Verzögerungsstufe (22-2), die eine folgende Verzögerungsstufe der ersten Verzögerungsstufe ist und zwischen die erste Verzögerungsstufe und einen Ausgang (OUT) des Ringoszillators gekoppelt ist, enthalten;
• eine erste Kondensatorbank (28-1), die zwischen einen Ausgang der ersten Verzögerungsstufe und Masse gekoppelt ist; und
• einen ersten Zeitsteuerungsblock (26-1), der konfiguriert ist, ein Ausgangssignal (N1) der ersten Verzögerungsstufe und mindestens ein erstes Steuersignal (CON1) zu empfangen, wobei:
• der Ausgang der ersten Verzögerungsstufe an einen Eingang der zweiten Verzögerungsstufe gekoppelt ist;
• das mindestens eine erste Steuersignal mindestens einen ersten Kondensator in der ersten Kondensatorbank bestimmt, der die Ringschleife verbindet oder trennt; und
• dann, wenn das Ausgangssignal der ersten Verzögerungsstufe eine erste bestimmte Bedingung erfüllt, der erste Zeitsteuerungsblock konfiguriert ist, das mindestens eine erste Steuersignal an die erste Kondensatorbank als mindestens ein erstes Schaltsignal weiterzugeben, und dann, wenn das Ausgangssignal der ersten Verzögerungsstufe nicht die erste bestimmte Bedingung erfüllt, der erste Zeitsteuerungsblock konfiguriert ist, zu deaktivieren, das mindestens eine erste Steuersignal an die erste Kondensatorbank weiterzugeben, so dass die Verbindung oder die Trennung des mindestens einen ersten Kondensators nicht bewirkt, dass sich eine Spannung am Ausgang der ersten Verzögerungsstufe über einen ersten Schwellenwert, der ein Auslöseniveau der zweiten Verzögerungsstufe ist, ändert.

2. Ringoszillator nach Anspruch 1, wobei:
• die erste Kondensatorbank den mindestens einen ersten Kondensator und mindestens einen ersten Schalter enthält;
• der mindestens eine erste Kondensator und der mindestens eine erste Schalter zwischen den Ausgang der ersten Verzögerungsstufe und Masse in Reihe geschaltet sind; und
• der mindestens eine erste Schalter durch das mindestens eine erste Schaltsignal gesteuert wird.

3. Ringoszillator nach Anspruch 2, wobei der mindestens eine erste Schalter ein Metall-Oxid-Halbleiter-Feldeffekttransistor-Schalter (MOSFET-Schalter) ist.

4. Ringoszillator nach Anspruch 2 oder 3, wobei:
• der erste Zeitsteuerungsblock mindestens ein erstes D-Latch und mindestens einen ersten Blockinverter enthält, wobei der erste Schwellenwert auch ein Auslöseniveau des mindestens einen ersten Blockinverters ist; und
• das mindestens eine erste D-Latch konfiguriert ist, das mindestens eine erste Steuersignal an einem Dateneingang des mindestens einen ersten D-Latches zu empfangen und das Ausgangssignal der ersten Verzögerungsstufe an einem Takteingang des mindestens einen ersten D-Latches durch den mindestens einen ersten Blockinverter zu empfangen, und konfiguriert ist, das mindestens eine Schaltsignal an den mindestens einen ersten Schalter in der ersten Kondensatorbank zu liefern, wobei:
• dann, wenn das Ausgangssignal der ersten Verzögerungsstufe niedriger als der erste Schwellenwert ist, das mindestens eine erste D-Latch das mindestens eine erste Steuersignal an den mindestens einen ersten Schalter in der ersten Kondensatorbank als das mindestens eine erste Schaltsignal weitergibt; und
• dann, wenn das Ausgangssignal der ersten Verzögerungsstufe höher als der erste Schwellenwert ist, das mindestens eine erste D-Latch das mindestens eine erste Steuersignal hält.

5. Ringoszillator nach Anspruch 2 oder 3, wobei:
• der erste Zeitsteuerungsblock mindestens ein erstes D-Flip-Flop und mindestens einen ersten Blockinverter enthält; und
• das mindestens eine erste D-Flip-Flop konfiguriert ist, das mindestens eine erste Steuersignal an einem Dateneingang des mindestens einen ersten D-Flip-Flops zu empfangen und das Ausgangssignal der ersten Verzögerungsstufe an einem Takteingang des mindestens einen ersten D-Flip-Flops durch den mindestens einen ersten Blockinverter zu empfangen, und konfiguriert ist, das mindestens eine erste Schaltsignal an den mindestens einen ersten Schalter in der ersten Kondensatorbank zu liefern, wobei:
• dann, wenn das Ausgangssignal der ersten Verzögerungsstufe an einer abfallenden Flanke einer Signalwellenform ist, das mindestens eine erste D-Flip-Flop das mindestens eine erste Steuersignal an den mindestens einen ersten Schalter in der ersten Kondensatorbank als das mindestens eine erste Schaltsignal weitergibt; und
• dann, wenn das Ausgangssignal der ersten Verzögerungsstufe nicht an der abfallende Flanke der Signalwellenform ist, das mindestens eine erste D-Flip-Flop das mindestens eine erste Steuersignal hält.

6. Ringoszillator nach einem vorhergehenden Anspruch, wobei:
• die erste Kondensatorbank mehrere erste Kondensatoren und mehrere erste Schalter enthält, wobei der mindestens eine erste Kondensator in den mehreren ersten Kondensatoren enthalten ist;
• jeder der mehreren ersten Kondensatoren und ein entsprechender der mehreren ersten Schalter zwischen den Ausgang der ersten Verzögerungsstufe und Masse in Reihe geschaltet sind; und
• das mindestens eine erste Schaltsignal mehrere erste Schaltsignale enthält und jeder der mehreren ersten Schalter durch ein entsprechendes der mehreren ersten Schaltsignale gesteuert wird.

7. Ringoszillator nach Anspruch 6, wobei:
• der erste Zeitsteuerungsblock mehrere erste D-Latches und einen ersten Blockinverter enthält, wobei der erste Schwellenwert auch ein Auslöseniveau des ersten Blockinverters ist;
• das mindestens eine erste Steuersignal mehrere erste Steuersignale enthält; und
• jedes der mehreren ersten D-Latches konfiguriert ist, ein entsprechendes der mehreren ersten Steuersignale an einem Dateneingang zu empfangen und das Ausgangssignal der ersten Verzögerungsstufe an einem Takteingang durch den ersten Blockinverter zu empfangen, und konfiguriert ist, das entsprechende der mehreren ersten Schaltsignale an den entsprechenden der mehreren ersten Schalter in der ersten Kondensatorbank zu liefern, wobei:
• dann, wenn das Ausgangssignal der ersten Verzögerungsstufe niedriger als der erste Schwellenwert ist, jedes der mehreren ersten D-Latches das entsprechende der mehreren ersten Steuersignale an den entsprechenden Schalter der mehreren ersten Schalter in der ersten Kondensatorbank als das entsprechende der mehreren ersten Schaltsignale weitergibt; und
• dann, wenn das Ausgangssignal der ersten Verzögerungsstufe höher als der erste Schwellenwert ist, jedes der mehreren ersten D-Latches das entsprechende der mehreren ersten Steuersignale hält.

8. Ringoszillator nach einem vorhergehenden Anspruch, der ferner eine zweite Kondensatorbank und einen zweiten Zeitsteuerungsblock umfasst, wobei:
• die zweite Kondensatorbank zwischen einen Ausgang der zweiten Verzögerungsstufe und Masse gekoppelt ist; und
• der zweite Zeitsteuerungsblock konfiguriert ist, ein Ausgangssignal der zweiten Verzögerungsstufe und mindestens ein zweites Steuersignal zu empfangen, wobei:
• das mindestens eine zweite Steuersignal mindestens einen zweiten Kondensator in der zweiten Kondensatorbank bestimmt, der die Ringschleife verbindet oder trennt; und
• dann, wenn das Ausgangssignal der zweiten Verzögerungsstufe eine zweite bestimmte Bedingung erfüllt, der zweite Zeitsteuerungsblock konfiguriert ist, das mindestens eine zweite Steuersignal an die zweite Kondensatorbank weiterzugeben, und dann, wenn das Ausgangssignal der zweiten Verzögerungsstufe nicht die zweite bestimmte Bedingung erfüllt, der zweite Zeitsteuerungsblock konfiguriert ist, das Weitergeben des mindestens einen zweiten Steuersignals an die zweite Kondensatorbank zu deaktivieren, so dass die Verbindung oder die Trennung des mindestens einen zweiten Kondensators in der zweiten Kondensatorbank nicht bewirkt, dass sich eine Spannung am Ausgang der zweiten Verzögerungsstufe über einen zweiten Schwellenwert, der das Auslöseniveau einer folgenden Verzögerungsstufe der zweiten Verzögerungsstufe ist, ändert.

9. Ringoszillator nach Anspruch 8, wobei:
• die erste Kondensatorbank den mindestens einen ersten Kondensator und mindestens einen ersten Schalter enthält;
• der mindestens eine erste Kondensator und der mindestens eine erste Schalter zwischen den Ausgang der ersten Verzögerungsstufe und Masse in Reihe geschaltet sind;
• der mindestens eine erste Schalter durch das mindestens eine erste Schaltsignal gesteuert wird;
• die zweite Kondensatorbank den mindestens einen zweiten Kondensator und mindestens einen zweiten Schalter enthält;
• der mindestens eine zweite Kondensator und der mindestens eine zweite Schalter zwischen den Ausgang der zweiten Verzögerungsstufe und Masse in Reihe geschaltet sind; und
• der mindestens eine zweite Schalter durch das mindestens eine zweite Schaltsignal gesteuert wird.

10. Ringoszillator nach Anspruch 9, wobei:
• der erste Zeitsteuerungsblock mindestens ein erstes D-Latch und mindestens einen ersten Blockinverter enthält, wobei der erste Schwellenwert auch ein Auslöseniveau des mindestens einen ersten Blockinverters ist;
• das mindestens eine erste D-Latch konfiguriert ist, das mindestens eine erste Steuersignal an einem Dateneingang des mindestens einen ersten D-Latches zu empfangen und das Ausgangssignal der ersten Verzögerungsstufe an einem Takteingang des mindestens einen ersten D-Latches durch den mindestens einen ersten Blockinverter zu empfangen, und konfiguriert ist, das mindestens eine Schaltsignal an den mindestens einen ersten Schalter in der ersten Kondensatorbank zu liefern, wobei:
• dann, wenn das Ausgangssignal der ersten Verzögerungsstufe niedriger als der erste Schwellenwert ist, das mindestens eine erste D-Latch das mindestens eine erste Steuersignal an den mindestens einen ersten Schalter in der ersten Kondensatorbank als das mindestens eine erste Schaltsignal weitergibt; und
• dann, wenn das Ausgangssignal der ersten Verzögerungsstufe höher als der ersten Schwellenwert ist, das mindestens eine erste D-Latch das mindestens eine erste Steuersignal hält;
• der zweite Zeitsteuerungsblock mindestens ein zweites D-Latch und mindestens einen zweiten Blockinverter enthält, wobei der zweite Schwellenwert auch ein Auslöseniveau des mindestens einen zweiten Blockinverters ist; und
• das mindestens eine zweite D-Latch konfiguriert ist, das mindestens eine zweite Steuersignal an einem Dateneingang des mindestens einen zweiten D-Latches zu empfangen und das Ausgangssignal der zweiten Verzögerungsstufe an einem Takteingang des mindestens einen zweiten D-Latches durch den mindestens einen zweiten Blockinverter zu empfangen, und konfiguriert ist, das mindestens eine zweite Schaltsignal an den mindestens einen zweiten Schalter in der zweiten Kondensatorbank zu liefern, wobei:
• dann, wenn das Ausgangssignal der zweiten Verzögerungsstufe niedriger als der zweite Schwellenwert ist, das mindestens eine zweite D-Latch das mindestens eine zweite Steuersignal an den mindestens einen zweiten Schalter in der zweiten Kondensatorbank als mindestens ein zweites Schaltsignal weitergibt; und
• dann, wenn das Ausgangssignal der zweiten Verzögerungsstufe höher als der zweite Schwellenwert ist, mindestens ein zweites D-Latch das mindestens eine zweite Steuersignal hält.

11. Ringoszillator nach einem vorhergehenden Anspruch, der ferner mehrere Kondensatorbänke und mehrere Zeitsteuerungsblöcke umfasst, wobei:
• die erste Kondensatorbank in den mehreren Kondensatorbänken enthalten ist und der erste Zeitsteuerungsblock in den mehreren Zeitsteuerungsblöcken enthalten ist;
• jede der mehreren Kondensatorbänke zwischen einen Ausgang einer entsprechenden der mehreren Verzögerungsstufen und Masse gekoppelt ist; und
• jeder der mehreren Zeitsteuerungsblöcke konfiguriert ist, mindestens ein Schaltsignal an eine entsprechende der mehreren Kondensatorbänke anhand eines Ausgangssignals der entsprechenden der mehreren Verzögerungsstufen zu liefern;
• auf jede der mehreren Verzögerungsstufen eine entsprechende der mehreren Kondensatorbänke folgt.

12. Ringoszillator nach einem vorhergehenden Anspruch, wobei die erste bestimmte Bedingung ist, dass das Ausgangssignal der ersten Verzögerungsstufe niedriger als der erste Schwellenwert ist.

13. Ringoszillator nach einem vorhergehenden Anspruch, wobei die erste bestimmte Bedingung ist, dass das Ausgangssignal der ersten Verzögerungsstufe an einer fallenden Flanke einer Wellenform ist.

14. Ringoszillator nach einem vorhergehenden Anspruch, wobei jede der Verzögerungsstufen durch einen Differenzialschaltungsinverter implementiert ist und 180 Grad-Phasenverschiebungen in der Ringschleife, die für eine Oszillation benötigt werden, durch eines erzielt werden, das aus der Gruppe ausgewählt ist, die Folgendes umfasst: Inversionen des Differenzialschaltungsinverters; und Austauschen eines Differenzialsignals von einem Differenzialschaltungszwischenspeicher zu einem benachbarten Differenzialschaltungszwischenspeicher.

15. Ringoszillator nach einem vorhergehenden Anspruch, der ferner eine Kappensteuereinheit umfasst, die konfiguriert ist, das mindestens eine erste Steuersignal zu liefern, wobei das mindestens eine erste Steuersignal von einem beliebigen Ausgangssignal an einem Ausgang jeder Verzögerungsstufe der mehreren Verzögerungsstufen entkoppelt ist.

## Revendications

1. Oscillateur en anneau (20) comprenant :
• une pluralité d'étages de retard (22-1, 22-2, 22-3) couplés en série dans une boucle en anneau (25), la pluralité d'étages de retard comportant un premier étage de retard (22-1) et un deuxième étage de retard (22-2), qui est un étage de retard qui suit le premier étage de retard, couplé entre le premier étage de retard et une sortie (OUT) de l'oscillateur en anneau ;
• une première batterie de condensateurs (28-1) couplée entre une sortie du premier étage de retard et la masse ; et
• un premier bloc de pilotage temporel (26-1) configuré pour recevoir un signal de sortie (N1) du premier étage de retard et au moins un premier signal de commande (CON1), dans lequel :
• la sortie du premier étage de retard est couplée à une entrée du deuxième étage de retard ;
• l'au moins un premier signal de commande détermine au moins un premier condensateur dans la première batterie de condensateurs à connecter ou déconnecter de la boucle en anneau ; et
• lorsque le signal de sortie du premier étage de retard remplit une première condition, le premier bloc de pilotage temporel est configuré pour transmettre l'au moins un premier signal de commande à la première batterie de condensateurs comme au moins un premier signal de commutation et, lorsque le signal de sortie du premier étage de retard ne remplit pas la première condition, le premier bloc de pilotage temporel est configuré pour désactiver la transmission de l'au moins un premier signal de commande à la première batterie de condensateurs, de sorte que la connexion ou la déconnexion de l'au moins un premier condensateur ne provoque pas une variation d'une tension à la sortie du premier étage de retard au-delà d'un premier seuil correspondant à un niveau de déclenchement du deuxième étage de retard.

2. Oscillateur en anneau selon la revendication 1, dans lequel :
• la première batterie de condensateurs comporte l'au moins un premier condensateur et au moins un premier interrupteur ;
• l'au moins un premier condensateur et l'au moins un premier interrupteur sont couplés en série entre la sortie du premier étage de retard et la masse ; et
• l'au moins un premier interrupteur est commandé par l'au moins un premier signal de commutation.

3. Oscillateur en anneau selon la revendication 2, dans lequel l'au moins un premier interrupteur est un interrupteur à transistor à effet de champ métal-oxyde-semi-conducteur (MOSFET).

4. Oscillateur en anneau selon la revendication 2 ou 3, dans lequel :
• le premier bloc de pilotage temporel comporte au moins un premier verrou D et au moins un premier inverseur de bloc, le premier seuil correspondant également à un niveau de déclenchement de l'au moins un premier inverseur de bloc ; et
• l'au moins un premier verrou D est configuré pour recevoir l'au moins un premier signal de commande sur une entrée de données de l'au moins un premier verrou D et pour recevoir le signal de sortie du premier étage de retard sur une entrée d'horloge de l'au moins un premier verrou D via l'au moins un premier inverseur de bloc, et configuré pour fournir l'au moins un premier signal de commutation à l'au moins un premier interrupteur dans la première batterie de condensateurs, dans lequel :
• lorsque le signal de sortie du premier étage de retard est inférieur au premier seuil, l'au moins un premier verrou D transmet l'au moins un premier signal de commande à l'au moins un premier interrupteur dans la première batterie de condensateurs comme l'au moins un premier signal de commutation ; et
• lorsque le signal de sortie du premier étage de retard est supérieur au premier seuil, au moins un premier verrou D maintient l'au moins un premier signal de commande.

5. Oscillateur en anneau selon la revendication 2 ou 3, dans lequel :
• le premier bloc de pilotage temporel comporte au moins une première bascule D et au moins un premier inverseur de bloc ; et
• l'au moins une première bascule D est configurée pour recevoir l'au moins un premier signal de commande sur une entrée de données de l'au moins une première bascule D et pour recevoir le signal de sortie du premier étage de retard sur une entrée d'horloge de l'au moins une première bascule D via l'au moins un premier inverseur de bloc, et configurée pour fournir l'au moins un premier signal de commutation à l'au moins un premier interrupteur dans la première batterie de condensateurs, dans lequel :
• lorsque le signal de sortie du premier étage de retard se trouve à un front descendant d'une forme d'onde de signal, l'au moins une première bascule D transmet l'au moins un premier signal de commande à l'au moins un premier interrupteur dans la première batterie de condensateurs comme l'au moins un premier signal de commutation ; et
• lorsque le signal de sortie du premier étage de retard ne se trouve pas au front descendant de la forme d'onde de signal, l'au moins une première bascule D maintient l'au moins un premier signal de commande.

6. Oscillateur en anneau selon l'une quelconque des revendications précédentes, dans lequel :
• la première batterie de condensateurs comporte une pluralité de premiers condensateurs et une pluralité de premiers interrupteurs, l'au moins un premier condensateur étant compris dans la pluralité de premiers condensateurs ;
• chacun de la pluralité de premiers condensateurs et un premier interrupteur correspondant de la pluralité de premiers interrupteurs sont couplés en série entre la sortie du premier étage de retard et la masse ; et
• l'au moins un premier signal de commutation comprend une pluralité de premiers signaux de commutation, et chacun de la pluralité de premiers interrupteurs est commandé par un premier signal de commutation correspondant de la pluralité de premiers signaux de commutation.

7. Oscillateur en anneau selon la revendication 6, dans lequel :
• le premier bloc de pilotage temporel comporte une pluralité de premiers verrous D et un premier inverseur de bloc, le premier seuil correspondant également à un niveau de déclenchement du premier inverseur de bloc ;
• l'au moins un premier signal de commande comporte une pluralité de premiers signaux de commande ; et
• chacun de la pluralité de premiers verrous D est configuré pour recevoir un premier signal de commande correspondant de la pluralité de premiers signaux de commande sur une entrée de données et pour recevoir le signal de sortie du premier étage de retard sur une entrée d'horloge via le premier inverseur de bloc, et configuré pour fournir le premier signal de commutation correspondant de la pluralité de premiers signaux de commutation au premier interrupteur correspondant de la pluralité de premiers interrupteurs dans la première batterie de condensateurs, dans lequel :
• lorsque le signal de sortie du premier étage de retard est inférieur au premier seuil, chacun de la pluralité de premiers verrous D transmet le premier signal de commande correspondant de la pluralité de premiers signaux de commande au premier interrupteur correspondant de la pluralité de premiers interrupteurs de la première batterie de condensateurs comme le premier signal de commutation correspondant de la pluralité de premiers signaux de commutation ; et
• lorsque le signal de sortie du premier étage de retard est supérieur au premier seuil, chacun de la pluralité de premiers verrous D maintient le premier signal de commande correspondant de la pluralité de premiers signaux de commande.

8. Oscillateur en anneau selon l'une quelconque des revendications précédentes, comprenant en outre une deuxième batterie de condensateurs et un deuxième bloc de pilotage temporel, dans lequel :
• la deuxième batterie de condensateurs est couplée entre une sortie du deuxième étage de retard et la masse ; et
• le deuxième bloc de pilotage temporel est configuré pour recevoir un signal de sortie du deuxième étage de retard et au moins un deuxième signal de commande, dans lequel :
• l'au moins un deuxième signal de commande détermine au moins un deuxième condensateur dans la deuxième batterie de condensateurs à connecter ou déconnecter de la boucle en anneau ; et
• lorsque le signal de sortie du deuxième étage de retard remplit une deuxième condition, le deuxième bloc de pilotage temporel est configuré pour transmettre l'au moins un deuxième signal de commande à la deuxième batterie de condensateurs et, lorsque le signal de sortie du deuxième étage de retard ne remplit pas la deuxième condition, le deuxième bloc de pilotage temporel est configuré pour désactiver la transmission de l'au moins un deuxième signal de commande à la deuxième batterie de condensateurs, de sorte que la connexion ou la déconnexion de l'au moins un deuxième condensateur dans la deuxième batterie de condensateurs ne provoque pas une variation d'une tension à la sortie du deuxième étage de retard au-delà d'un deuxième seuil correspondant à un niveau de déclenchement d'un étage de retard qui suit le deuxième étage de retard.

9. Oscillateur en anneau selon la revendication 8, dans lequel :
• la première batterie de condensateurs comporte l'au moins un premier condensateur et au moins un premier interrupteur ;
• l'au moins un premier condensateur et l'au moins un premier interrupteur sont couplés en série entre la sortie du premier étage de retard et la masse ;
• l'au moins un premier interrupteur est commandé par l'au moins un premier signal de commutation ;
• la deuxième batterie de condensateurs comporte l'au moins un deuxième condensateur et au moins un deuxième interrupteur ;
• l'au moins un deuxième condensateur et l'au moins un deuxième interrupteur sont couplés en série entre la sortie du deuxième étage de retard et la masse ; et
• l'au moins un deuxième interrupteur est commandé par l'au moins un deuxième signal de commutation.

10. Oscillateur en anneau selon la revendication 9, dans lequel :
• le premier bloc de pilotage temporel comporte au moins un premier verrou D et au moins un premier inverseur de bloc, le premier seuil correspondant également à un niveau de déclenchement de l'au moins un premier inverseur de bloc ;
• l'au moins un premier verrou D est configuré pour recevoir l'au moins un premier signal de commande sur une entrée de données de l'au moins un premier verrou D et pour recevoir le signal de sortie du premier étage de retard sur une entrée d'horloge de l'au moins un premier verrou D via l'au moins un premier inverseur de bloc, et configuré pour fournir l'au moins un premier signal de commutation à l'au moins un premier interrupteur dans la première batterie de condensateurs, dans lequel :
• lorsque le signal de sortie du premier étage de retard est inférieur au premier seuil, l'au moins un premier verrou D transmet l'au moins un premier signal de commande à l'au moins un premier interrupteur dans la première batterie de condensateurs comme l'au moins un premier signal de commutation ; et
• lorsque le signal de sortie du premier étage de retard est supérieur au premier seuil, au moins un premier verrou D maintient l'au moins un premier signal de commande ;
• le deuxième bloc de pilotage temporel comporte au moins un deuxième verrou D et au moins un deuxième inverseur de bloc, le deuxième seuil correspondant également à un niveau de déclenchement de l'au moins un deuxième inverseur de bloc ; et
• l'au moins un deuxième verrou D est configuré pour recevoir l'au moins un deuxième signal de commande sur une entrée de données de l'au moins un deuxième verrou D et pour recevoir le signal de sortie du deuxième étage de retard sur une entrée d'horloge de l'au moins un deuxième verrou D via l'au moins un deuxième inverseur de bloc, et configuré pour fournir l'au moins un deuxième signal de commutation à l'au moins un deuxième interrupteur dans la deuxième batterie de condensateurs, dans lequel :
• lorsque le signal de sortie du deuxième étage de retard est inférieur au deuxième seuil, l'au moins un deuxième verrou D transmet l'au moins un deuxième signal de commande à l'au moins un deuxième interrupteur dans la deuxième batterie de condensateurs comme l'au moins un deuxième signal de commutation ; et
• lorsque le signal de sortie du deuxième étage de retard est supérieur au deuxième seuil, au moins un deuxième verrou D maintient l'au moins un deuxième signal de commande.

11. Oscillateur en anneau selon l'une quelconque des revendications précédentes, comprenant en outre une pluralité de batteries de condensateurs et une pluralité de blocs de pilotage temporel, dans lequel :
• la première batterie de condensateurs est comprise dans la pluralité de batteries de condensateurs, et le premier bloc de pilotage temporel est compris dans la pluralité de blocs de pilotage temporel ;
• chacune de la pluralité de batteries de condensateurs est couplée entre une sortie d'un étage de retard correspondant de la pluralité d'étages de retard et la masse ; et
• chacun de la pluralité de blocs de pilotage temporel est configuré pour fournir au moins un signal de commutation à une batterie de condensateurs correspondante de la pluralité de batteries de condensateurs sur la base d'un signal de sortie de l'étage de retard correspondant de la pluralité d'étages de retard ;
• chacun de la pluralité d'étages de retard est suivi d'une batterie de condensateurs correspondante de la pluralité de batteries de condensateurs.

12. Oscillateur en anneau selon l'une quelconque des revendications précédentes, dans lequel la première condition est que le signal de sortie du premier étage de retard est inférieur au premier seuil.

13. Oscillateur en anneau selon l'une quelconque des revendications précédentes, dans lequel la première condition est que le signal de sortie du premier étage de retard se trouve à un front descendant d'une forme d'onde.

14. Oscillateur en anneau selon l'une quelconque des revendications précédentes, dans lequel chacun de la pluralité d'étages de retard est mis en œuvre par un inverseur à circuit différentiel, et les déphasages de 180 degrés dans la boucle en anneau nécessaires à l'oscillation sont obtenus par un élément sélectionné dans le groupe comprenant : des inversions de l'inverseur à circuit différentiel ; et l'interversion du signal différentiel d'un tampon à circuit différentiel vers un tampon à circuit différentiel adjacent.

15. Oscillateur en anneau selon l'une quelconque des revendications précédentes, comprenant en outre un contrôleur de condensateurs, configuré pour fournir l'au moins un premier signal de commande, l'au moins un premier signal de commande étant découplé de tout signal de sortie à une sortie de chaque étage de retard de la pluralité d'étages de retard.
